# EUROPÄISCHE PATENTANMELDUNG

(11) **EP 1 120 826 A1**
(43) Veröffentlichungstag der Anmeldung: **01.08.2001**
(21) Anmeldenummer: 01200186.3
(22) Anmeldetag: 18.01.2001
(51) Int. Cl.: H01L 21/60, H01L 23/492

(54) **Halbleiterbauelement mit Metallschicht**

(30) Priorität: 27.01.2000 DE 10003539
(71) Anmelder: Philips Corporate Intellectual Property GmbH, 52064 Aachen (DE); Koninklijke Philips Electronics N.V., 5621 BA Eindhoven (NL)
(72) Erfinder: Rother, Michael, c/o Philips Corporate, 52064 Aachen (DE)
(74) Vertreter: Volmer, Georg, Dipl.-Ing.

(57) **Zusammenfassung**

Die Erfindung beschreibt ein Halbleiterbauelement, welches eine Metallschicht mit Gold und Germanium aufweist. Auf der Metallschicht befindet sich eine dünne Deckschicht aus Germaniumoxid, welche die darunterliegende Metallschicht vor unerwünschter Oxidation des Germaniums schützt. Die Erfindung beschreibt auch ein Verfahren zur Herstellung eines solchen Halbleiterbauelementes.

## Beschreibung

Die Erfindung betrifft ein Halbleiterbauelement, welches eine Metallschicht aus einer binären oder ternären Gold-Germanium-Legierung aufweist, und ein Verfahren zur Herstellung eines solchen Halbleiterbauelementes.

Zur Herstellung von Halbleiterbauteile werden zunächst diskrete Halbleiterbauelemente wie beispielsweise Transistoren und Systeme von Transistoren mit anderen Bauelementen, wie zum Beispiel digitale Transistoren, Dioden, Sensoren, Widerstände oder kleine Kapazitäten, hergestellt. Dazu erzeugt man auf einer Siliciumscheibe (Wafer) gleichzeitig mehrere tausend solcher diskreten Bauelemente.

Die Siliciumscheibe wird dann in einzelne Transistorsysteme (Chips) zerschnitten.
Jedes dieser Systeme wird auf einem Träger befestigt, mit elektrischen Zuleitungen versehen und in ein Gehäuse eingebaut. Die eingehausten Transistoren, Dioden usw. werden dann mit dem Gehäuse in Schaltungen oder Baugruppen eingelötet.

Es sind verschiedene Verfahren bekannt, um ein Halbleiterbauelement auf einem Träger oder einem Chipbefestigungsteil zu befestigen.

Aus der EP 0 756 325 A2 ist eine Halbleitervorrichtung bekannt, die einen Träger, ein auf diesen Träger angebrachtes Halbleiterbauelement und zwischen dem Halbleiterbauelement und dem Träger eine Gold und Germanium enthaltende Metallschicht umfasst, wobei auf einer Oberfläche des Halbleiterbauelementes mehrere Metallschichten abgeschieden sind und auf die oberste Metallschicht die Gold und Germanium enthaltende Metallschicht aufgebracht ist. Die Montage des Halbleiterbauelementes auf den Träger erfolgte durch Löten.

Um den Vorteil einer niedrigen Löttemperatur nutzen zu können, wird in der obersten Metallschicht das eutektische Mischungsverhältnis von Gold und Germanium verwendet.

Voraussetzung für eine optimale Löttemperatur ist jedoch ein schmalbandiger Toleranzbereich des Mischungsverhältnisses. Germanium zeigt jedoch das Bestreben an die Schichtoberfläche zu wandern. Dort wird das Germanium unkontrolliert oxidiert und das Mischungsverhältnis Gold / Germanium ändert sich.

Aufgabe dieser Erfindung ist es, ein Halbleiterbauelement zur Verfügung zu stellen, welches eine Gold und Germanium enthaltende Metallschicht aufweist, die eine verbesserte Langzeitstabilität in ihrer Zusammensetzung zeigt.

Erfindungsgemäß wird die Aufgabe gelöst durch ein Halbleiterbauelement, welches eine Metallschicht aus einer binären oder ternären Gold-Germanium-Legierung enthält, und auf der Metallschicht eine Deckschicht aus Germaniumoxid aufweist.

Die Deckschicht aus Germaniumoxid versiegelt die Metallschicht, welche Germanium und Gold enthält, und verhindert so weiteres, unkontrolliertes Wachstum von Germaniumoxid. Beim Auflöten des Halbleiterbauelementes auf einen Träger liegt das Mischungsverhältnis von Gold und Germanium immer noch im gewünschten Bereich.

Die Erfindung betrifft auch ein Verfahren zur Herstellung eines Halbleiterbauelementes, bei dem
- auf einem halbleitenden Substrat p- und n-leitende Bereiche erzeugt werden,
- auf der Rückseite des halbleitenden Substrats eine Metallschicht, die eine binäre oder ternäre Gold-Germanium-Legierung enthält, aufgebracht wird und
- die Metallschicht einer Atmosphäre von Hexamethyldisilazan ausgesetzt wird und
- und das Halbleiterbauelement anschließend in einer sauerstoffhaltigen Atmosphäre gelagert wird.

Nachdem das Halbleiterelement erzeugt und die Metallschicht mit Gold und Germanium aufgebracht wurde, wird die Metallschicht einer Atmosphäre von Hexamethyldisilazan ausgesetzt. Während dieses Prozesses bildet sich auf der Oberfläche der Metallschicht mit Germanium und Gold eine dünne Schicht aus Kristallisationskeimen aus. Bei Lagerung in sauerstoffhaltiger Atmosphäre bildet sich dann eine Deckschicht aus Germaniumoxid aus.

Ähnlich wie bei der Bildung von Al₂O₃ auf Al-Schichten, ist die Bildung von Germaniumoxid selbstlimitierend.

Im folgenden soll die Erfindung eingehender und anhand von zwei Ausführungsbeispielen erläutert werden.

Ein Halbleiterbauelement kann ein diskreter bipolarer Transistor, insbesondere ein Planar-transistor oder ein Feldeffekttransistor, aber auch eine Halbleiterdiode, insbesondere eine Flächendioden oder eine Schottky-Diode, weiterhin ein Sensorbauelement oder eine Kombination eines Transistors mit anderen Bauelementen, zum Beispiel ein digitaler Transistor sein.

Diese oder andere Halbleiterbauelemente werden mittels einer Metallschicht auf einem Träger oder ein Chipbefestigungsteil, der eine weitere Metallschicht trägt, aufgelötet und anschließend in einem Gehäuse gefasst. Nachdem sie mit elektrischen Anschlüssen versehen worden ist, kann sie zum Bestücken von Leiterplatten usw. eingesetzt werden.

Die Halbleiterbauelemente werden überwiegend aus Silicium gefertigt. Für diskrete Bauelemente handelt es sich meistens um ein dünnes dotiertes Siliciumplättchen mit einer Schichtdicke von 0.05 bis 0.6 mm und einem Querschnitt von 0.02 bis 20 mm².

Auf der Unterseite des Halbleiterbauelementes wird eine Metallschicht aus einer binären oder ternären Gold-Germanium-Legierung, mit einem bevorzugten Germaniumgehalt von 4 bis 20 Gew.-% aufgebracht. Es können ternäre Gold-Germanium-Legierungen mit beispielsweise Bor oder Antimon als drittem Legierungsbestandteil eingesetzt werden.

Alternativ können zwischen Halbleiterbauelement und der Metallschicht mit Gold und Germanium weitere metallische Schichten aufgebracht sein.

Anschließend wird die Metallschicht einer Atmosphäre von Hexamethyldisilazan (HMDS) ausgesetzt. Dies kann beispielsweise dadurch realisiert werden, dass gasförmiges HMDS zusammen mit einem Trägergas wie zum Beispiel N₂ über die Metallschicht aus Gold und Germanium geleitet wird. Das HMDS schlägt sich als viele, kleine Kristallisationskeime auf der Oberfläche der Metallschicht nieder. Durch diese vielen Kristallisationspunkte findet anschließend bei Lagerung in sauerstoffhaltiger Atmosphäre eine kontrollierte, sich selbst limitierende Oxidation des Germaniums an der Oberfläche der Metallschicht statt und es bildet sich eine dünne, monomolekulare Deckschicht aus Germaniumoxid aus. Nach Ausbildung der geschlossenen Germaniumoxid-Schicht unterbleibt eine weitere Oxidation des Germaniums und das Mischungsverhältnis Gold / Germanium bleibt konstant.

Die Montage auf den Träger erfolgt im allgemeinen durch Löten, insbesondere durch Hartlöten. Dazu muss auch der Träger mit einer lötfähigen metallischen Schicht versehen sein. Diese Lötbeschichtung kann beispielsweise aus Silber, Gold oder einer Sn/Pb-Legierung bestehen.

Im folgenden werden zwei Ausführungsformen der Erfindung erläutert, die beispielhafte Realisierungsmöglichkeiten darstellen.

### Ausführungsbeispiel 1

Zur Herstellung von NPN-Transistoren wurden auf der Vorderseite einer n-dotierten Siliciumsubstratscheibe in bekannter Art und Weise die p- und n-leitenden Bereiche erzeugt. Dann wurde auf die Rückseite der Siliciumsubstratscheibe eine Metallschicht aus Gold und Germanium mit einem Germaniumgehalt von 12 Gew.-% und einer Dicke von 1.3 µm abgeschieden.

Anschließend wurde gasförmiges HMDS zusammen mit N₂ als Trägergas über die Oberfläche der Metallschicht aus Gold und Germanium geleitet. Bei Lagerung in sauerstoffhaltiger Atmosphäre bildet sich auf der Metallschicht eine dünne Deckschicht aus GeO₂ aus.

Die so metallisierte Siliciumsubstratscheibe wurde mittels einer Diamantsäge in einzelne Chips getrennt. Die Chips wurden auf einen silberplattierten Träger aufgelötet. Auf diese Art und Weise wurden Halbleiterbauelemente hergestellt, die jeweils einen diskreten NPN-Transistor-Chip enthielten.

### Ausführungsbeispiel 2

Zur Herstellung von PNP-Transistoren wurden auf der Vorderseite einer p-dotierten Siliciumsubstratscheibe in bekannter Art und Weise die p- und n-leitenden Bereiche erzeugt. Dann wurde auf die Rückseite der Siliciumsubstratscheibe eine Metallschicht aus Gold und Germanium mit einem Gehalt an Germanium von 12 Gew.-% und einer Dicke von 1.3 µm abgeschieden.

Anschließend wurde gasförmiges HMDS zusammen mit N₂ als Trägergas über die Oberfläche der Metallschicht aus Gold und Germanium geleitet. Bei Lagerung in sauerstoffhaltiger Atmosphäre bildet sich auf der Metallschicht eine dünne Deckschicht aus GeO₂ aus.

Die so metallisierte Siliciumsubstratscheibe wurde mittels einer Diamantsäge in einzelne Chips getrennt. Die Chips wurden auf einen silberplattierten Träger aufgelötet.

Auf diese Art und Weise wurden Halbleiterbauelemente hergestellt, die jeweils einen diskreten PNP-Transistor-Chip enthielten.

## Patentansprüche

1. Halbleiterbauelement, welches eine Metallschicht aus einer binären oder ternären Gold-Germanium-Legierung enthält, und auf der Metallschicht eine Deckschicht aus Germaniumoxid aufweist.

2. Verfahren zur Herstellung eines Halbleiterbauelementes, bei dem
- auf einem halbleitenden Substrat p- und n-leitende Bereiche erzeugt werden,
- auf der Rückseite des halbleitenden Substrats eine Metallschicht, die eine binäre oder ternäre Gold-Germanium-Legierung enthält, aufgebracht wird und
- die Metallschicht einer Atmosphäre von Hexamethyldisilazan ausgesetzt wird und
- und das Halbleiterbauelement anschließend in einer sauerstoffhaltigen Atmosphäre gelagert wird.
